Europäisches Patentamt

European Patent Office

Office européen des brevets

(19)

(11) Publication number: **0 196 155**
**A2**

(12) # EUROPEAN PATENT APPLICATION

(21) Application number: **86300864.5**

(22) Date of filing: **10.02.86**

(51) Int. Cl.⁴: **H 01 L 21/316, H 01 L 21/28**

(30) Priority: **23.03.85 GB 8507601**

(43) Date of publication of application: **01.10.86**
**Bulletin 86/40**

(84) Designated Contracting States: **DE FR IT NL**

(71) Applicant: **STC plc, 190 Strand, London, WC2R 1DU (GB)**

(72) Inventor: **Scovell, Peter Denis, 14, Stablecroft, Springfield Chelmsford Essex (GB)**
Inventor: **Baker, Roger Leslie, 7, Third Avenue, Chelmsford Essex (GB)**

(74) Representative: **Dennis, Mark Charles et al, STC Patent Department Edinburgh Way, Harlow Essex CM20 2SH (GB)**

(54) **Method of forming an oxide film on a semiconductor substrate.**

(57) A method of producing thin, e.g. 0.8 to 20 nm, oxide films on a silicon substrate includes pulse heating the substrate in an oxidising atmosphere to a peak temperature exceeding 500°C and typically in the range 700 to 1200°C. The oxide film can be used e.g. as a gate dielectric in MOS technology.

EP 0 196 155 A2

TITLE MODIFIED
see front page

## IMPROVEMENTS IN INTEGRATED CIRCUITS

This invention relates to integrated circuits and in particular to the formation of insulating films in the fabrication of such circuits.

A key step in the fabrication of many integrated circuits is the formation of a thin insulating oxide layer, e.g. for use as a gate dielectric. As the density of integration is increased the oxide thickness has reduced to the point at which uniformity is becoming difficult to achieve. In conventional silicon processing, for example, oxide films are grown by exposure of the semiconductor to oxygen or steam at temperatures in excess of $700°C$ for a period of several minutes to a few hours. With the present need for oxide films of 10nm thickness or less the conventional process can no longer provide the high degree of uniformity and reproducibility that is necessary for industrial processing.

The object of the present invention is to minimise or to overcome this disadvantage.

According to the invention there is provided a method of forming a thin uniform oxide film on a semiconductor surface, the method including pulse heating the semiconductor in an oxidising atmosphere to a peak temperature exceeding $500°C$.

We have found that rapid heating of a silicon wafer in an oxidising atmosphere to a peak temperature

exceeding 500°C and then maintaining that temperature for a short time provides a thin oxide layer on the semiconductor surface. Heating may be achieved thermally or by the use of microwaves, laser radiation or incoherent optical radiation.

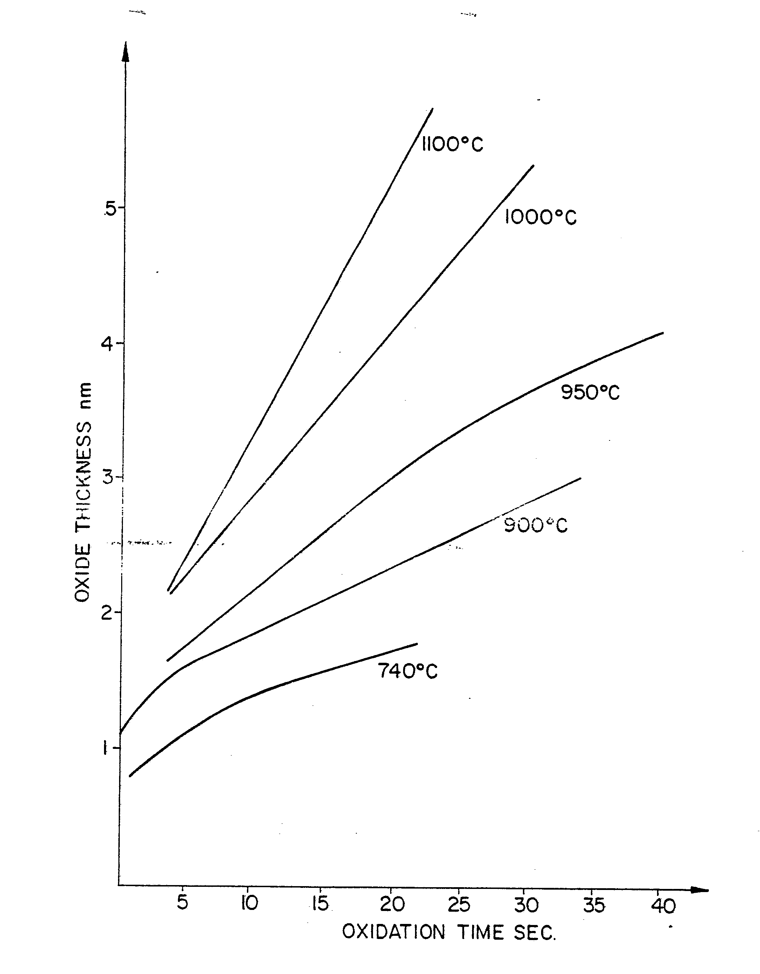

An embodiment of the invention will now be described with reference to the accompanying drawing in which the single figure illustrates the relationship between oxide film thickness and oxidation time.

In a typical process a silicon wafer is polished and cleaned and is then exposed to an oxidising atmosphere, e.g. oxygen or steam. The wafer is rapidly heated to a peak temperature exceeding 500°C and advantageously in the range 700 to 1200°C, and is maintained at the peak temperature for a period of 1 to 60 seconds after which it is allowed to cool to ambient temperature. Advantageously the peak temperature is 900 to 1000°C and the wafer is maintained at that temperature for 5 to 35 seconds.

This short high temperature excursion provides a thin uniform oxide film on the semiconductor surface. The film may serve e.g. as a gate insulator during subsequent processing to form an integrated circuit. Typically the film thickness is 0.8 to 20nm.

The film thickness is determined by the peak temperature, the heating time and the partial pressure of the oxidising agent in the atmosphere in which heating is performed. As an example of the use of the technique we have oxidised silicon wafers by heating to 700 to 1100°C for times of 1 to 45 seconds in an A.G. Associates Heatpulse 210T system. All oxidations were performed in pure oxygen at atmospheric pressure. The results for the peak temperature range of 740 to 1100°C are shown in the accompanying drawing. Optical measurements of these films show a refractive index of 1.45 and Auger electron spectroscopy shows them to be stoichiometric. Reproducibility is high, typically

$\pm$ 0.2nm for a 2.0nm film thickness. The film growth rate is significantly faster than that achieved by conventional techniques.

In further applications a low partial pressure of oxygen can be used, e.g. in a vacuum system where electron beam heating may be employed, for the controlled growth of very thin films. Similarly the use of high pressures, typically 1 to 20 atmospheres, can be used to provide high growth rates.

The oxide film can be used as a gate dielectric in MOS technology and for interfacial treatments for polysilicon devices in bipolar technology.

CLAIMS:-

1. A method of forming a thin uniform oxide film on a semiconductor surface, the method including pulse heating the semiconductor in an oxidising atmosphere to a peak temperature exceeding $500^{\circ}C$.

2. A process as claimed in claim 1, wherein the semiconductor is heated to a temperature of 700 to $1200^{\circ}C$.

3. A process as claimed in claim 1 or 2, wherein the peak temperature is maintained for a period of 1 to 60 seconds.

4. A process as claimed in claim 2, wherein the peak temperature is 740 to $1100^{\circ}C$.

5. A process as claimed in claim 4, wherein the peak temperature is maintained for 1 to 45 seconds.

6. A process as claimed in any one of claims 1 to 5, wherein the film thickness is 0.8 to 20nm.

7. A process as claimed in any one of claims 1 to 6, wherein the oxidising atmosphere is maintained under reduced pressure.

8. A process as claimed in any one of claims 1 to 7, wherein the semiconductor is heated by an electron beam.

9. A process as claimed in any one of claims 1 to 7, wherein the semiconductor is heated by microwave or optical radiation.

10. A process for surface oxidation of a semiconductor substantially as described herein with reference to the accompanying drawing.

11. A semiconductor wafer provided with a surface oxide film by a process as claimed in any one of claims 1 to 10.

12. An integrated circuit fabricated from a wafer as claimed in claim 11.

///